Europäisches Patentamt

European Patent Office

Office européen des brevets

(19)

(11) Publication number : **0 502 647 A2**

## (12) EUROPEAN PATENT APPLICATION

(21) Application number : 92301635.6

(22) Date of filing : 26.02.92

(51) Int. Cl.⁵ : **H01L 23/532,** H01L 21/90

(30) Priority : 28.02.91 US 662196

(43) Date of publication of application :
09.09.92 Bulletin 92/37

(84) Designated Contracting States :
DE FR GB IT

(71) Applicant : **SGS-THOMSON MICROELECTRONICS, INC.**
1310 Electronics Drive
Carrollton Texas 75006 (US)

(72) Inventor : **Hata, William Y.**
4565 Hallmark Drive
Plano, Collin County, Texas 75024 (US)

(74) Representative : **Palmer, Roger et al**
PAGE, WHITE & FARRER 54 Doughty Street
London WC1N 2LS (GB)

(54) Conductive structure for integrated circuits.

(57)   An aluminum layer formed over a semiconductor integrated circuit. A metal layer is formed over the aluminum layer, and both are etched to define a conductive signal line. Another metal layer is deposited and etched back to form a sidewall metal regions, so that the aluminum in the conductive signal line is surrounded on the top and sides. The metallic layer used to form the sidewall regions can be selectively deposited to minimize the amount of etchback required. In the resulting structure, the metal side and top layers contain the aluminum in the signal line, and therefore help prevent problems caused by aluminum electromigration.

FIG. 4

EP 0 502 647 A2

Jouve, 18, rue Saint-Denis, 75001 PARIS

The present invention relates generally to semiconductor integrated circuits, and more specifically to a technique for forming metallic conductive structures for integrated circuits.

Highly conductive structures are often needed to connect different parts of semiconductor integrated circuits. Various metals are typically used for at least some of these interconnecting structures due to their low resistivity. Aluminum and aluminum alloys are popularly used for this purpose because of their high conductivity, processing of aluminum is easily controllable, and because of aluminum's good adhesion properties to underlying layers such as silicon dioxide.

One drawback to the use of aluminum as an interconnect for integrated circuits is that moderate to high current densities tend to cause electromigration of the aluminum. Current densities sufficient to cause electromigration are often found in the very small geometry semiconductor devices now being made, even with the use of lower operating voltages. Electromigration causes aluminum to physically move, so that gaps can be formed in conductive lines. If such gaps, or even significantly thinner than usual regions, are formed, the integrated circuit device is generally rendered inoperable.

It would be desirable to provide a metal signal line structure which is resistant to electromigration. Such a structure would preferably be highly conductive, and easy to include in standard semiconductor integrated circuit process flows.

It is therefore an object of the present invention to provide a method for forming a metal conductive structure for semiconductor integrated circuits.

It is another object of the present invention to provide such a method which results in a highly conductive structure.

It is a further object of the present invention to provide such a method which is compatible with standard integrated circuit manufacturing process flows.

Therefore, according to the present invention, an aluminum layer is formed over a semiconductor integrated circuit. A metal layer is formed over the aluminum layer, and both are etched to define a conductive signal line. Another metal layer is deposited and etched back to form metal sidewall regions, so that the aluminum in the conductive signal line is surrounded on the top and sides. The metallic layer used to form the sidewall regions can be selectively deposited to minimize the amount of etchback required. In the resulting structure, the metal side and top layers contain the aluminum in the signal line, and therefore help prevent problems caused by aluminum electromigration.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

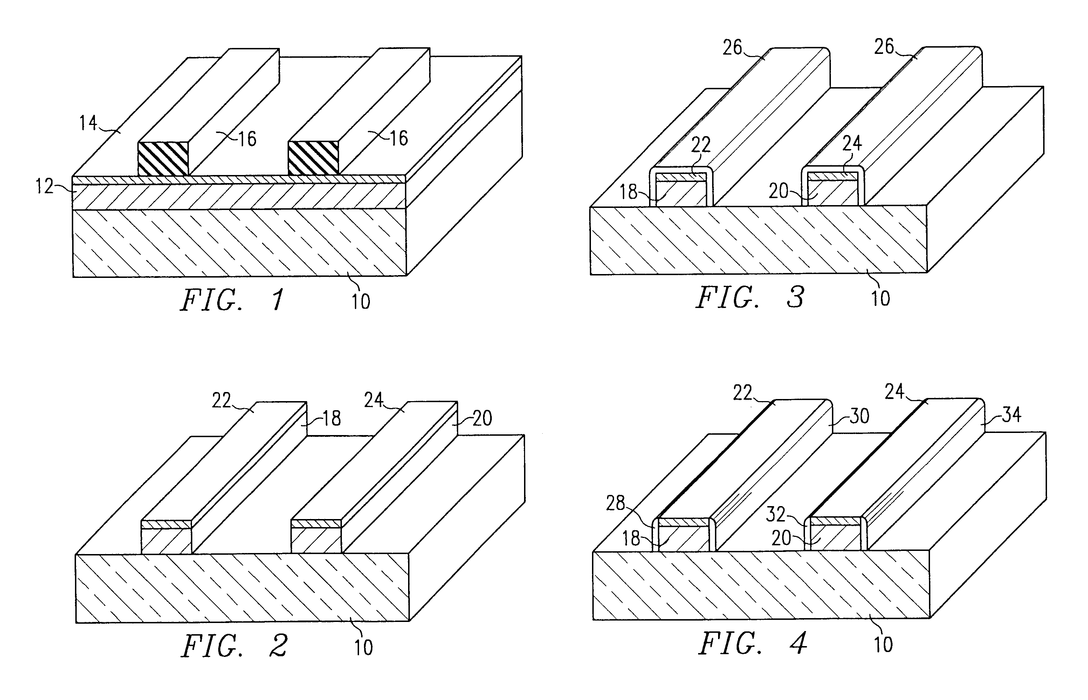

**Figures 1 - 4** illustrate a preferred method for forming metal conductive structures according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1** two adjacent signal lines are to be formed on a portion of an integrated circuit. The signal lines illustrated, for purposes of example, as being formed over a field oxide region **10**. As will be apparent to those skilled in the art, the described technique will be used to form metallic conductive structures over various underlying features of the integrated circuit device. However, for purposes of simplicity, a portion of two signal lines passing over the field oxide region **10** is illustrated in the figures.

An aluminum layer **12** is formed over the surface of the device, followed by formation of a titanium nitride layer **14**. If desired, an optional barrier layer (not shown) can be formed over the device before the aluminum layer **12** is formed. The aluminum layer 12 is deposited to a thickness which is desired for the metal interconnect layer, and can be, for example, approximately 4,000 to 12,000 angstroms thick. The titanium nitride layer **14** functions as an antireflective coating, and will later perform the additional function of providing a cap layer to aluminum interconnect lines. The titanium nitride layer **14** is preferably deposited to a thickness of between approximately 200 and 500 angstroms to for the antireflective coating.

If desired, other metal layers may be used in place of titanium nitride. For purposes of the present invention, it is important that the metal used in layer **14** is capable of inhibiting hillock formation and electromigration in the underlying aluminum. Therefore, metals which do not function as an antireflective coating can be used in place of the titanium nitride. However, the use of titanium nitride provides both such inhibition of hillock formation and an antireflective coating, thus being beneficial in two respects and therefore preferred.

A layer of photoresist **16** is spun on and patterned to define interconnect lines. Two such lines are shown in **Figure 1**, as defined by the photoresist region **16**.

Referring to **Figure 2**, the titanium nitride **14** and aluminum **12** layers are anisotropically etched using the photoresist region **16** as a mask. This results in the formation of two aluminum signal lines **18, 20**. Each signal line has a cap layer of titanium nitride **22, 24** respectively. The photoresist **16** is then removed, resulting in the structure shown in **Figure 2**.

Referring to **Figure 3**, a layer of tungsten **26** is selectively grown over the surface of the integrated circuit. As is known in the art, selective tungsten deposition causes a tungsten layer **26** to be formed on conductive regions, such as aluminum interconnect **18, 20** and titanium nitride cap layers **22, 24**. Tungsten forms in these regions in preference to formation on insulating regions such as field oxide layer **10**. This causes the complete encapsulation of the aluminum interconnect and titanium nitride cap layers by tungsten **26**.

Referring to **Figure 4**, the tungsten **26** is anisotropically etched to form tungsten sidewall regions **28, 30, 32, 34**. Sidewalls **28, 30** completely encapsulate the sides of aluminum signal line **18**, while sidewalls **32, 34** completely encapsulate the sides of aluminum signal line **20**. The sidewall regions **28 - 34**, in combination with the titanium nitride cap layers **22, 24**, completely encapsulate tthe top and sides of the aluminum signal lines **18, 20**.

An important advantage of the method just described is related to the techniques used to selectively deposit tungsten. If encapsulation of the aluminum interconnect line **18, 20** is attempted by simply selectively depositing tungsten, a highly selective deposition process must be performed. Such highly selective processes are known to attack aluminum to some degree, degrading the quality of the aluminum signal line **18, 20**. Less selective processes which do not attack the aluminum in the signal line typically deposit some tungsten on insulator surfaces. This can result in a tungsten bridge between adjacent signal lines, causing an electrical short which interferes with the functioning of the device.

With the technique described above, a partially selective tungsten deposition process can be used. This prevents damage to the aluminum signal lines **18, 20**. The anisotropic etch used to form spacers **28 - 34** will remove any small amounts of tungsten which may be deposited on the surface of the field oxide layer **10**. This prevents any electrical shorting between signal lines. The result is that there is no problem caused by shorting adjacent signal lines through tungsten bridges, and high quality aluminum signal lines are retained.

The combination of a titanium nitride cap layer **22, 24**, with the tungsten sidewalls **28 - 34** greatly inhibits electromigration of the aluminum during operation of the integrated circuit. Hillock formation during subsequent processing steps is also inhibited. This helps prevent this common failure mode of integrated circuit devices, which can greatly extend the average operating lifetime of integrated circuits fabricated using the described technique.

The titanium nitride layer **14** acts as an antireflective coating, so that signal line definition is improved during the exposure and patterning of photoresist layer **16**. No additional photomasking is required beyond the single masking layer already required to define the aluminum signal lines **18, 20**. All of the remaining steps are self-aligning.

As is known in the art, tungsten etches easily in fluorine based chemistries. These chemistries are preferred for the anisotropic etching of the tungsten layer **26** because aluminum is not affected by these chemistries. Titanium nitride etches in fluorine based chemistries to some extent, but significant etching occurs only in the presence of significant amounts of free fluorine or under a high power ionic bombardment. If a low power anisotropic etch is used, the titanium nitride cap layers **22, 24** will not etch significantly, so that the aluminum signal lines **18, 20** will remain fully encapsulated.

While the invention has been particularly shown and described with reference to a preferred embodiment, it will be understood by those skilled in the art that various changes in form and detail may be made therein without departing from the spirit and scope of the invention.

**Claims**

1.  A method for forming conductive signal lines on a semiconductor integrated circuit device, comprising the steps of:
    depositing a layer of a first metal material over the integrated circuit;
    etching the metal layer to form a signal line having sides and a top; and
    forming a casing of a second metal material, different form the first metal material, on the signal line, wherein the casing covers the sides of the signal line.

2.  The method of Claim 1, wherein said forming step comprises:
    forming a top layer of a third metal material over the signal line; and
    forming sidewalls of the second metal material on the sides of the signal line.

3.  The method of Claim 2, wherein said top layer forming step comprises the step of:
    before said etching step, depositing a layer of the third metal on the first metal layer, wherein the layer of third metal material is etched during said etching step to define a signal line having a top covering of the third metal material.

4.  The method of Claim 2, wherein said sidewall forming step comprises the step of:

selectively depositing the second metal material on the top layer and on the sides of the signal line.

5. The method of Claim 2, wherein said sidewall forming step comprises the steps of:

depositing a layer of the second metal material over the device; and

anisotropically etching the layer of second metal material to form sidewalls on the sides of the signal line.

6. The method of Claim 5, wherein said anisotropic etch step comprises selectively etching the second metal material over the third metal material.

7. The method of Claim 5, wherein said second metal material layer depositing step selectively deposits the second metal material on underlying conductive materials, whereby such layer has a greater thickness on exposed surfaces of the first and third metal materials than on any exposed surfaces of insulating materials.

8. A conductive element for a semiconductor integrated circuit device, comprising:

an elongate element on a surface of the device, said element being formed from a first metal material and having a top and sides;

a top metal layer covering the top of the elongate element, said top metal layer being formed from a metal material different from the first metal material; and

metal sidewalls covering the sides of said elongate element, said sidewalls being formed from a metal material different from the first metal material.

9. The conductive element of Claim 8, wherein said top metal layer is formed form a second metal material, and wherein said sidewalls are formed from a third metal material different from the second metal material.

10. The conductive element of Claim 9, wherein said third metal material comprises tungsten.

11. The conductive element of Claim 9 or 10 where in the second metal material is suitable for functioning as an antireflective coating for the first metal material layer.

12. The conductive element of any of Claims 9 to 11, wherein the second metal material comprises titanium nitride.

13. The conductive element as claimed in any of claims 8 to 12, wherein the first metal material comprises aluminium.

EP 0 502 647 A2

FIG. 1

FIG. 3

FIG. 2

FIG. 4